# EUROPEAN PATENT APPLICATION

(11) **EP 4 407 335 A1**
(43) Date of publication of application: **31.07.2024**
(21) Application number: 23153106.2
(22) Date of filing: 24.01.2023
(51) Int. Cl.: G01R 33/34, G01R 33/3815, G01R 33/3875, H10N 60/01

(54) **SHIMMING A MAGNETIC RESONANCE IMAGING SYSTEM**

(71) Applicant: Koninklijke Philips N.V., 5656 AG Eindhoven (NL)
(72) Inventor: FORTHMANN, Peter, Eindhoven (NL)
(74) Representative: Philips Intellectual Property & Standards

(57) **Abstract**

The invention relates to a shim coil (1) for a magnetic assembly (4) of a magnetic resonance imaging system (5), comprising a backing plate (2) and a coil pattern (3) on the backing plate (2), which is held by the backing plate (2) and which forms the windings of the shim coil (1), wherein the coil pattern (3) comprises a superconductor. In this way, a versatile shim coil (1) for a magnetic assembly (4) of a magnetic resonance imaging system (5) is provided which can be manufactured in an easy and repeatable way.

## Description

### FIELD OF THE INVENTION

The invention relates to the field of shimming a magnetic resonance imaging (MRI) system and more particularly to a shim coil for a magnetic assembly of a magnetic resonance imaging system and a manufacturing method for such a shim coil.

### BACKGROUND OF THE INVENTION

Even following the most rigorous manufacturing tolerances, the homogeneity of a newly setup magnet for a magnetic resonance imaging (MRI) system is typically more than one orders of magnitude away from an ideal specification level. Once the MRI system is installed on its place, its field will be further distorted by the presence of metal in pipes, wires, ducts, and rebar and structural beams in the environment of the MRI system. Fringe fields of nearby scanners may also affect the field of the newly installed magnet.

Therefore, shimming measures are taken to improve the homogeneity of the MRI system. Hence, shimming is the process by which the main magnetic field (B0) is made more homogenous. Shimming may be passive, active or both. In passive shimming, pieces of sheet metal or ferromagnetic modules are affixed at various locations within and/or around the scanner bore, while active shimming uses currents directed through specialized coils to generate a corrective magnetic field. Therefore, in active shimming, currents are directed through specialized coils to further improve homogeneity.

The approach underlying most of active shimming methods is based on spherical harmonic analysis. First, by field mapping, various unwanted harmonic components in the inhomogeneous field are identified. For each unwanted spherical harmonic component in the uncorrected magnetic field, a controlled supplemental magnetic field is generated by passing current through an active shim gradient. This supplemental shim field shall have the same spatial distribution but shall be equal and opposite to the unwanted component. By super-positioning and merging these two opposite magnetic fields together, neutralization and cancellation of the magnetic field error inhomogeneity is achieved as much as possible.

Active shim coils can be superconducting shim coils, located within the liquid helium-containing cryostat of the main magnet or resistive shim coils, mounted on the same support structure as the gradient coils within the inner walls of the scanner. Both types of active shimming require their own power supplies and are controlled by special circuitry.

Superconducting shim coils are commonly encountered in magnets with fields of 3 T or higher and are rarely used in lower field strength scanners. Typically, a superconducting shim coil is embedded in the cryostat of the main magnet just beyond the main coil windings and may correct for several orders of inhomogeneity. More than one shim coil may be used and each shim coil can be individually powered during the shimming process and has a switch allowing it to be placed in persistent superconducting mode once the desired field correction has been obtained. Unlike resistive shims, the current in superconducting shims and the magnetic fields they generate cannot be easily changed once set.

Further, it is common that superconducting magnets may be used for MRI systems. To realize superconductivity, a magnet includes one or more electrically conductive coils, which are formed from superconducting wire. To maintain superconductivity for conventional superconductors, a cryogenic environment (cryostat) at a temperature near absolute zero during operation is necessary. In the superconducting state, the electrically conductive coils are referred to as superconducting coils, which effectively have no electrical resistance, and therefore conduct much larger electric currents to create strong magnetic fields. In this respect, ordinary metallic superconductors are well known, which usually work below 77 K. Further, there exist high-temperature superconductors (HTS) which are defined as materials that behave as superconductors at temperatures above 77 K, the boiling point of liquid nitrogen, one of the simplest coolants in cryogenics.

In this respect, US 10,460,862 B2 describes a MgB₂ superconducting thin-film wire as a HTS that exhibits good J_{c} characteristics even under a 20 K magnetic field and a method for producing such a wire. The MgB₂ superconducting thin-film wire includes a long substrate and an MgB₂ thin film formed on the long substrate. The MgB₂ thin film has a micro texture such that MgB₂ columnar crystal grains stand densely together on the surface of the long substrate and has a T_{c} of 30 K or higher. In grain boundary regions of the MgB₂ columnar crystal grains, a predetermined transition metal element is dispersed and segregated. The predetermined transition metal element is an element having a body-centered cubic lattice structure.

### SUMMARY OF THE INVENTION

It is an object of the invention to provide a versatile shim coil for a magnetic assembly of a magnetic resonance imaging system which can be manufactured in an easy and repeatable way.

According to the invention, this object is addressed by the subject matter of the independent claims. Preferred embodiments of the invention are described in the dependent claims.

Therefore, according to the invention, a shim coil for a magnetic assembly of a magnetic resonance imaging system is provided, comprising a backing plate and a coil pattern on the backing plate, which is held by the backing plate and which forms the windings of the shim coil, wherein the coil pattern comprises a superconductor.

In this way, i.e. by the aid of the backing plate, a shim coil may also be formed from materials which are not suitable for forming wires like ceramic superconducting materials.

In general, different superconductors can be used for the coil pattern. However, according to a preferred embodiment of the invention, the coil pattern comprises a high temperature superconductor, preferably MgB₂.

As mentioned above, there exist high-temperature superconductors (HTS) which are defined as materials that behave as superconductors at temperatures above 77 K. However, most high-temperature superconductors are ceramic materials. Ceramic superconductors are becoming suitable for some practical use, but they still have many manufacturing issues and there are only few successful practical examples of employment. Most ceramics are brittle, which makes the fabrication of wires from them problematic. This problem is addressed by arranging the superconductor material on the backing plate.

Further, magnesium diboride (MgB₂) is a promising superconductor with a higher operating temperature than conventional NbTi conductors. MgB₂ becomes superconducting below 39 K; this is far less than the about 150 K of YBaCuO-HTC material, but still has the advantage that cooling capacity is much higher at the maximum temperature of 39 K for MgB₂ than at the maximum temperature of 9.7 K for cooling NbTi. This relaxes many of the thermal constraints that drive the cost of a cryostat for magnetic resonance imaging (MRI cryostat). Therefore, many of the thermal constraints that drive the cost of a cryostat for MRI cryostat may be solved in this way.

In general, the backing plate may be designed in different ways. However, according to a preferred embodiment of the invention, the backing plate has a cylindrical shape, preferably with open ends. Such a design may be well used for a shim coil for a MRI system.

Further, according to a preferred embodiment of the invention, the backing plate and the coil pattern form a printed circuit board. In this respect, it is especially preferred that the backing plate comprises glass-reinforced epoxy laminate material. It has been found that such a material for the backing plate is very resistant and provides for an excellent basis for forming the coil pattern thereon. Such glass-reinforced epoxy laminate material is preferably FR-4, also referred to by "FR4". This is a designation for glass-reinforced epoxy laminate material. FR-4 is a composite material composed of woven fiberglass cloth with an epoxy resin binder that is flame resistant, i.e. self-extinguishing.
"FR" stands for "flame retardant". FR-4 glass epoxy is a versatile high-pressure thermoset plastic laminate grade with good strength to weight ratios. With near zero water absorption, FR-4 may be used as an electrical insulator possessing considerable mechanical strength. The material retains its high mechanical values and electrical insulating qualities in both dry and humid conditions. These attributes, along with good fabrication characteristics, lend utility to the material also for low temperature applications.

Furthermore, according to a preferred embodiment of the invention, the backing plate comprises a steel foil. Such a steel foil may be used instead of or in combination with an epoxy laminate material.

Further, according to the invention, it is proposed to use a shim coil as described before in a cryostat of a magnetic resonance imaging system, wherein the cryostat comprises a superconducting main magnet for generating the B0 field of the magnetic resonance imaging system.

In this respect, the invention is also related to a magnetic assembly of a magnetic resonance imaging system, comprising a cryostat with a superconducting main magnet for generating the B0 field of the magnetic resonance imaging system, wherein the cryostat further comprises a shim coil as described above.

Furthermore, according to the invention, a method of manufacturing a shim coil as described above is provided, comprising the following method steps:
S1) arranging material comprising i) pre-reacted MgB₂ powder or ii) Mg powder and B powder on the backing plate for forming the coil pattern,
   and
S2) heat treating the arranged material.
Preferably, the step of arranging pre-reacted MgB₂ powder or Mg powder and B powder on the backing plate for forming the coil pattern is performed by a press. The use of a press provides for accurate placement of the superconducting material on the backing plate.

Further, it is preferred that the step of heat treating the arranged material is performed in an oven, the oven having a baker with a groove pattern corresponding to the coil pattern. In this way, the groove pattern of the baker provides for helping to maintain the shape of the superconducting material originally formed on the backing plate.

According to an alternative preferred embodiment of the invention, the step of heat treating the arranged material is performed by a selective laser sintering process. Selective laser sintering (SLS) is an additive manufacturing technique that uses a laser as the power and heat source to sinter powdered material, aiming the laser automatically at points in space defined by a 3D model, binding the material together to create a solid structure. This technique is similar to selective laser melting.

To return to the above-mentioned method according to the invention: Preferably, in case i) the heat treating is performed at a temperature between 930 C and 1000 C, preferably at 965 C, for a time between 2 min and 6 min, preferably for 4 min. Further, it is preferred that in case ii) the heat treating is performed at a temperature between 600 C and 750 c, preferably at 650 C, for a time between 30 min and 50 min, preferably for 40 min.

### BRIEF DESCRIPTION OF THE DRAWINGS

These and other aspects of the invention will be apparent from and elucidated with reference to the embodiments described hereinafter. Such an embodiment does not necessarily represent the full scope of the invention, however, and reference is made therefore to the claims and herein for interpreting the scope of the invention.

In the drawings:
Fig. 1 schematically depicts a shim coil according to a preferred embodiment of the invention in a perspective view,
Fig. 2 depicts a flowchart of a manufacturing method according to a preferred embodiment of the invention,
Fig. 3 schematically depicts a magnetic resonance imaging system with a shim coil as shown in Fig. 1,
Fig. 4 schematically depicts a press for forming the coil pattern on the backing plate according to a preferred embodiment of the invention and
Fig. 5 schematically depicts an oven with a baker which comprises a groove pattern corresponding to the coil pattern according to a preferred embodiment of the invention.

### DETAILED DESCRIPTION OF EMBODIMENTS

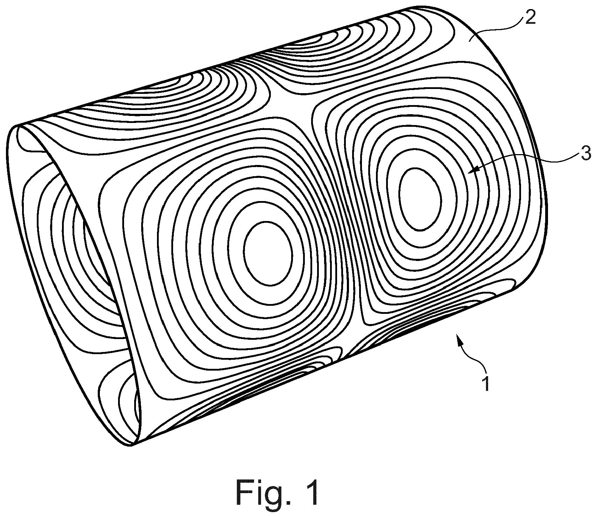

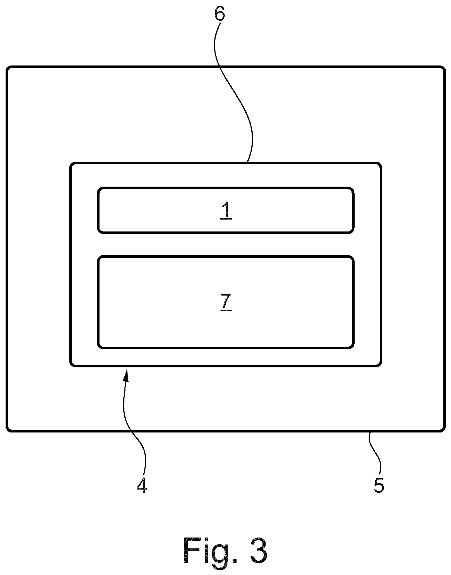

Fig. 1 schematically depicts a shim coil 1 according to a preferred embodiment of the invention in a perspective view. The shim coil 1 may be used for a magnetic assembly 4 with a superconducting main magnet 7 for generating the B0 field of a magnetic resonance imaging system 5 as schematically depicted in Fig. 3. The shim coil 1 comprises a backing plate 2 and a coil pattern 3 on the backing plate 2, which is held by the backing plate 2 and which forms the windings of the shim coil 1. The backing plate 2 has a cylindrical shape with open ends. This design makes it especially suitable for using it as a shim coil 1 for a superconducting main magnet 7 for generating the B0 field of a magnetic resonance imaging system 5 in a MRI cryostat 6.

The coil pattern 3 comprises a high temperature superconductor, namely MgB₂. As briefly mentioned before, there exist high-temperature superconductors (HTS) which are defined as materials that behave as superconductors at temperatures above 77 K, the boiling point of liquid nitrogen. However, most high-temperature superconductors are ceramic materials which have many manufacturing issues. Especially, most high-temperature superconductors are brittle, which makes the fabrication of wires from them problematic. However, according to the invention, no wires have to be formed from HTCs. Instead, the superconductor material is arranged on the backing plate and, therefore, is formed in such a way that windings required by the shim coil 1 may be formed in a repeatable and reliable way.

Here, magnesium diboride (MgB₂) is used as the material for the windings of the shim coil 1. MgB₂ also is a superconductor with a higher operating temperature than conventional NbTi conductors. MgB₂ becomes superconducting below 39 K; this is far less than the about 150 K of YBaCuO-HTC material, but still has the advantage that cooling capacity is much higher at 39 K than at 9.7 K, which is required for cooling NbTi. Therefore, it has been found that MgB₂ is a material which is highly suitable for forming the windings of the shim coil 1.

The shim coil 1 according to the preferred embodiment of the invention described here is equipped with a backing plate 2, which comprises glass-reinforced epoxy laminate material. Therefore, the backing plate 2 and the coil pattern 3 together form a printed circuit board. Instead of or in addition to glass-reinforced epoxy laminate material the backing plate 2 may also comprise a steel foil.

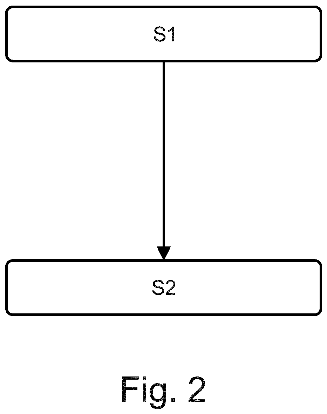

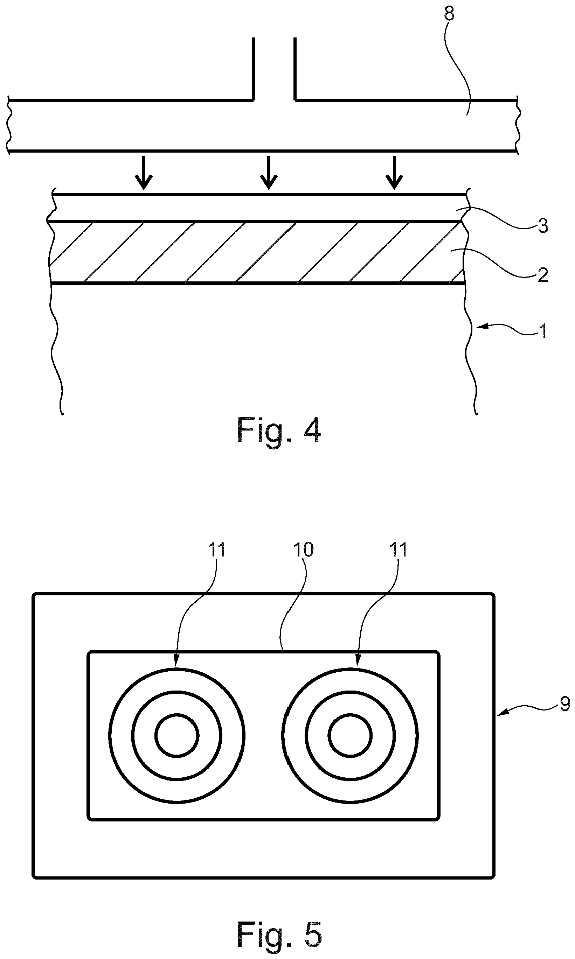

Fig. 2 depicts a flowchart of a manufacturing method according to a preferred embodiment of the invention. This method comprises essentially two method steps:
In step S1 material comprising i) pre-reacted MgB₂ powder or ii) Mg powder and B powder on is arranged on the backing plate 2 for forming the coil pattern 3. This means, that the material is arranged on the backing plate 2 in such a way that the shape of the coil pattern 3 is already achieved, however not yet in a durable design. A durable design is only achieved in the second step S2 in which the arranged material is heat treated. Here, the step of arranging pre-reacted MgB₂ powder or Mg powder and B powder on the backing plate 2 for forming the coil pattern 3 is performed by a press 8 which is schematically depicted in Fig. 4: The material is arranged on the backing plate according to the shape of the coil pattern 3 and a press 8 is used to fix the material in that shape. Then, the step of heat treating the arranged material is performed in an oven 9, wherein the oven 9 is equipped with a baker 10 with has a groove pattern 11 corresponding to the coil pattern 3. This is schematically depicted in Fig. 5 which shows the oven 9, the baker 10 and groove patterns 11 which relate to the shape of the coil pattern 3 as schematically shown in Fig. 1.

It should be noted that different heat-treating steps are applied depending on whether i) pre-reacted MgB₂ powder or ii) Mg powder and B powder on is arranged on the backing plate 2 for forming the coil pattern 3. In case i) the heat treating is performed at a temperature of 965 C, for a time of 4 min. On the other side, in case ii) the heat treating is performed at a temperature of 650 C, for a time of 40 min.

While the invention has been illustrated and described in detail in the drawings and foregoing description, such illustration and description are to be considered illustrative or exemplary and not restrictive; the invention is not limited to the disclosed embodiments. Other variations to the disclosed embodiments can be understood and effected by those skilled in the art in practicing the claimed invention, from a study of the drawings, the disclosure, and the appended claims. In the claims, the word "comprising" does not exclude other elements or steps, and the indefinite article "a" or "an" does not exclude a plurality. The mere fact that certain measures are recited in mutually different dependent claims does not indicate that a combination of these measures cannot be used to advantage. Any reference signs in the claims should not be construed as limiting the scope. Further, for the sake of clearness, not all elements in the drawings may have been supplied with reference signs.

### REFERENCE SYMBOL LIST

| | |
|---|---|
| shim coil | 1 |
| backing plate | 2 |
| coil pattern | 3 |
| magnetic assembly | 4 |
| magnetic resonance imaging system | 5 |
| cryostat | 6 |
| superconducting main magnet | 7 |
| press | 8 |
| oven | 9 |
| baker | 10 |
| groove pattern | 11 |

## Claims

1. Shim coil (1) for a magnetic assembly (4) of a magnetic resonance imaging system (5), comprising a backing plate (2) and a coil pattern (3) on the backing plate (2), which is held by the backing plate (2) and which forms the windings of the shim coil (1), wherein the coil pattern (3) comprises a superconductor.

2. Shim coil (1) according to claim 1, wherein the coil pattern (3) comprises a high temperature superconductor, preferably MgB₂.

3. Shim coil (1) according to claim 1 or 2, wherein the backing plate (2) has a cylindrical shape.

4. Shim coil (1) according to any of the preceding claims, wherein the backing plate (2) and the coil pattern (3) form a printed circuit board.

5. Shim coil (1) according to any of the preceding claims, wherein the backing plate (2) comprises glass-reinforced epoxy laminate material.

6. Shim coil (1) according to any of the preceding claims, wherein the backing plate (2) comprises a steel foil.

7. Use of a shim coil (1) according to any of claims 1 to 6 in a cryostat (6) of a magnetic resonance imaging system (5), wherein the cryostat (6) comprises a superconducting main magnet (7) for generating the B0 field of the magnetic resonance imaging system (5).

8. Magnetic assembly (4) of a magnetic resonance imaging system (5), comprising a cryostat (6) with a superconducting main magnet (7) for generating the B0 field of the magnetic resonance imaging system (5), wherein the cryostat (6) further comprises a shim coil (1) according to any of claims 1 to 6.

9. Method of manufacturing a shim coil (1) according to any of claims 1 to 6, comprising the following method steps:
S1) arranging material comprising i) pre-reacted MgB₂ powder or ii) Mg powder and B powder on the backing plate (2) for forming the coil pattern (3),and
S2) heat treating the arranged material.

10. Method according to claim 9, wherein the step of arranging pre-reacted MgB₂ powder or Mg powder and B powder on the backing plate (2) for forming the coil pattern (3) is performed by a press (8).

11. Method according to claim 9 or 10, wherein the step of heat treating the arranged material is performed in an oven (9), the oven (9) having a baker (10) with a groove pattern (11) corresponding to the coil pattern (3).

12. Method according to claim 9 or 10, wherein the step of heat treating the arranged material is performed by a selective laser sintering process.

13. Method according to any of claims 9 to 12, wherein in case i) the heat treating is performed at a temperature between 930 C and 1000 C, preferably at 965 C, for a time between 2 min and 6 min, preferably for 4 min.

14. Method according to any of claims 9 to 12, wherein in case ii) the heat treating is performed at a temperature between 600 C and 750 c, preferably at 650 C, for a time between 30 min and 50 min, preferably for 40 min.
